# FASCICULE DE BREVET EUROPEEN

(11) **EP 2 074 700 B1**
(45) Date de publication et mention de la délivrance du brevet: **28.08.2013**
(21) Numéro de dépôt: 07821117.4
(22) Date de dépôt: 10.10.2007
(51) Int. Cl.: H04B 1/26, H03D 7/16

(54) **MODULE D'EMISSION ET DE RECEPTION RADIOELECTRIQUE, ADAPTE NOTAMMENT AUX RADIOCOMMUNICATIONS LARGE BANDE**
HAUPTSÄCHLICH FÜR DIE BREITBAND-FUNKKOMMUNIKATION BESTIMMTES RADIOELEKTRISCHES SENDE- UND EMPFANGSMODUL
RADIOELECTRIC TRANSMISSION AND RECEPTION MODULE MAINLY INTENDED FOR BROAD-BAND RADIOCOMMUNICATIONS

(30) Priorité: 13.10.2006 FR 0608996
(43) Date de publication de la demande: 01.07.2009
(73) Titulaire: Thales, 92200 Neuilly Sur Seine (FR)
(72) Inventeur: DUSSAUBY, Marie-Pierre, F-95320 Saint Leu La Foret (FR); JAHIER, Vincent, F-95150 TAVERNY (FR); GIRAUDO, Michel, F-92500 Rueil Malmaison (FR); FLOUZAT, Christophe, F-92260 Fontenay Aux Roses (FR)
(74) Mandataire: Lucas, Laurent Jacques
(86) Numéro de dépôt international: PCT/EP2007/060749
(87) Numéro de publication internationale: WO 2008/043776

(56) Documents cités:
- EP-A2- 0 408 066
- JP-A- 6 125 368
- JP-A- 9 074 369
- US-A1- 2006 019 623
- PNEUMATIKAKIS A ET AL: "A 900MHz/1800MHz/1900MHz superhet receiver engaging high IF1 for image rejection" DEVICES, CIRCUITS AND SYSTEMS, 2000. PROCEEDINGS OF THE 2000 THIRD IEEE INTERNATIONAL CARACAS CONFERENCE ON MARCH 15-17, 2000, PISCATAWAY, NJ, USA,IEEE, 15 mars 2000 (2000-03-15), pages 401-406, XP010512091 ISBN: 0-7803-5766-3

## Description

L'invention concerne un module d'émission et de réception radioélectrique. En particulier, l'invention s'applique aux modules logiciel de radiocommunication pouvant recevoir et/ou émettre en large bande, c'est-à-dire dans une plage de fréquences allant de 30 MHz à 3 GHz (soit la bande de fréquences couramment désignée par l'acronyme anglo-saxon VHF pour Very High Frequency et la bande de fréquences couramment désignée par l'acronyme anglo-saxon UHF pour Ultra High Frequency).

Certains modules d'émission et de réception radioélectrique sont programmables par voie logiciel pour pouvoir s'adapter à une gamme de signaux s'étendant sur une large plage de fréquences (dont l'étendue couvre plusieurs gigahertz). Ces modules dit logiciel peuvent encore s'adapter plus généralement à de nombreuses formes d'onde. L'intérêt suscité par de tels modules, notamment pour la versatilité qu'ils offrent, explique leur utilisation dans un nombre grandissant de dispositif.

En conséquence, ces modules doivent pouvoir s'adapter à de nombreuses contraintes. Parmi ces contraintes, figurent principalement la réduction des coûts de conception et de production, la compacité volumique et la consommation électrique. S'ajoute encore l'atteinte des performances (par exemple de rapport signal/bruit ou encore de débits de transmission,...) exigées en fonction de chacune des utilisations desdits modules.

De tels modules sont aujourd'hui conçus à l'aide de composants électriques développés spécifiquement (plus généralement désigné par l'acronyme anglo-saxon ASIC pour Application Specific Integrated Circuit) et en conséquence implique un coût de développement élevé. En outre, les modules actuels ont une consommation électrique élevée, limitant de fait les domaines d'utilisation.

En outre, dans les modules radio très contraints en terme de performances, les éléments polluant radioélectriquement tels les synthétiseurs (générateurs de fréquence tel que les oscillateurs de transposition et la source de référence) sont isolés dans des modules spécifiques avec des boitiers mécaniques indépendants. Les différentes fonctions sont donc réparties sur plusieurs cartes interconnectés, ce qui augmente significativement le coût de production de ces modules radio.

Le document "A 900MHz/1800MHz/1900MHz superhet receiver engaging high IF1 for image rejection , A.Pneumatikakis et al " décrit un récepteur superhétérodyne comportant un module radiofréquence, un module fréquence intermédiaire haute et un module fréquence intermédiaire basse pour des applications GSM. Le système décrit dans ce document ne permet pas de réaliser de façon compacte, un système qui présente en outre une fonction d'émission ainsi que deux voies de communications sur deux bandes de fréquences distinctes, telles les bandes UHF et VHF.

L'invention a notamment pour but de pallier les inconvénients précités. A cet effet, l'invention a notamment pour objet un module d'émission et de réception radioélectrique selon la revendication 1.

Dans un mode de réalisation, le module fréquence intermédiaire haute reçoit sur la première entrée des signaux radioélectriques sur la bande de fréquences 225 - 520 MHz, et d'autre part des signaux radioélectriques sur la bande de fréquences 30-88MHz. Le module comporte une voie en émission et une voie en réception pour la bande de fréquences 225 - 520 MHz et une voie en émission et une voie en réception pour la bande de fréquences 30-88MHz. Le module comporte un filtre passe-bas dont la fréquence de coupure sensiblement égale à 600 MHz, un mélangeur, des amplificateurs, des filtres passe-bande, un filtre passe haut 70MHz, des amplificateurs et un mélangeur. Pour la voie en réception, le signal reçu sur la première entrée est envoyé au filtre passe-bas, le signal filtré par le filtre passe-bas étant mélangé par le mélangeur au signal reçu sur une troisième entrée reliée à un premier module oscilateur local. Le signal résultant du mélangeur est filtré et amplifié, puis mélangé par le mélangeur au signal reçu sur la quatrième entrée. Le signal est ensuite acheminé vers la seconde sortie. Pour la voie en émission, le signal reçu sur une seconde entrée est mélangé par le mélangeur au signal provenant d'une quatrième entrée reliée à un second module oscilateur local, filtré et amplifié, puis mélangé par le mélangeur au signal reçu sur la troisième entrée, puis filtré par le filtre passe-bas, le signal étant ensuite acheminé vers la première sortie.

Dans un mode de réalisation, le premier module oscillateur local comporte un oscillateur contrôlé en tension adapté à délivrer un signal de fréquence compris entre 1250 et 1820 MHz. Le module comporte un dispositif de type boucle à verrouillage de phase et un filtre passe-bas. Le module reçoit sur une entrée un signal dont la fréquence est sensiblement stable et sensiblement égale à 160 MHz. Le signal est délivré par un cristal oscillant contrôlé en tension compris dans un module horloge. Le signal reçu de l'entrée pilote le dispositif de type boucle à verrouillage de phase qui génère un signal transitant par le filtre et pilotant la fréquence du signal généré par l'oscillateur contrôlé en tension, ce dernier signal étant transmis à la troisième entrée du module fréquence intermédiaire haute et au dispositif de type boucle à verrouillage de phase pour asservissement.

Dans un mode de réalisation, le second module oscillateur local comporte un oscillateur contrôlé en tension adapté à délivrer un signal de fréquence compris entre 1150 et 1290 MHz. Le module comporte un dispositif de type boucle à verrouillage de phase et un filtre passe-bas. Le module reçoit sur une entrée un signal dont la fréquence est sensiblement stable et sensiblement égale à 160 MHz. Le signal est délivré par un cristal oscillant contrôlé en tension compris dans un module horloge. Le signal reçu de l'entrée pilote le dispositif de type boucle à verrouillage de phase qui génère un signal transitant par le filtre et pilotant la fréquence du signal généré par l'oscillateur contrôlé en tension, ce dernier signal étant transmis à la quatrième entrée du module fréquence intermédiaire haute et au dispositif de type boucle à verrouillage de phase pour asservissement. La fréquence du signal émis sur la sortie du second module oscillateur local peut être choisie inférieure ou supérieure à la fréquence intermédiaire haute, la vitesse de changement de fréquence se faisant à la vitesse de sauts en fréquence du signal émis et/ou reçu par le module d'émission et de réception radioélectrique.

Dans un mode de réalisation, le module fréquence intermédiaire basse reçoit sur la première entrée des signaux radioélectriques sur la bande de fréquences intermédiaire haute, et d'autre part des signaux radioélectriques sur la bande de fréquences 30-88MHz. Le module comporte un filtre passe-bas dont la fréquence de coupure sensiblement égale à 70 MHz, des amplificateurs, un banc de filtres suiveur comprenant des filtres passe-bande, un filtre anti-repliement, des atténuateurs variables, un limiteur et un commutateur. Pour la voie en réception, le signal reçu sur la première entrée est envoyé au filtre passe-bas, amplifié, atténué, filtré par le banc de filtres suiveurs, puis amplifié, atténué, amplifié, filtré par le filtre anti-repliement et limité. Le signal est ensuite acheminé vers la seconde sortie. Pour la voie en émission, le signal reçu sur la seconde entrée est envoyé au filtre passe-bas, amplifié, atténué, et filtré par le banc de filtres suiveurs, puis amplifié. Le signal est ensuite routé vers le commutateur qui bloque ou redirige vers le filtre passe-bas le signal. Le signal est ensuite acheminé vers la première sortie.

Tous les éléments non actifs du module d'émission et de réception radioélectrique peuvent être éteints.

L'invention a notamment pour avantage qu'elle permet d'avoir des mélanges parasites d'ordre élevé. Les réponses parasites sont beaucoup moins nombreuses que pour une fréquence traditionnellement plus basse. La structure fréquence intermédiaire haute du module permet de gagner au moins 20dB sur les performances suivantes
○ Rejection de la fréquence intermédiaire
○ Rejection de la fréquence image
○ Rejection des fréquences des oscillateurs locaux
○ Réponses parasites en réception
○ Raies parasites en émission

D'autres caractéristiques de l'invention apparaîtront à l'aide de la description qui suit donnée à titre non limitatif faite en regard des dessins annexés qui représentent :
- la figure 1, un synoptique représentant les modules compris dans le module d'émission et de réception radioélectrique selon l'invention ;
- la figure 2, un synoptique représentant un mode de réalisation du module radiofréquence selon l'invention ;
- la figure 3, un synoptique représentant un module fréquence intermédiaire haute selon l'invention ;
- la figure 4, un synoptique illustrant un mode de réalisation du module oscillateur local selon l'invention ;
- la figure 5, un synoptique illustrant un mode de réalisation du module fréquence intermédiaire basse selon l'invention.

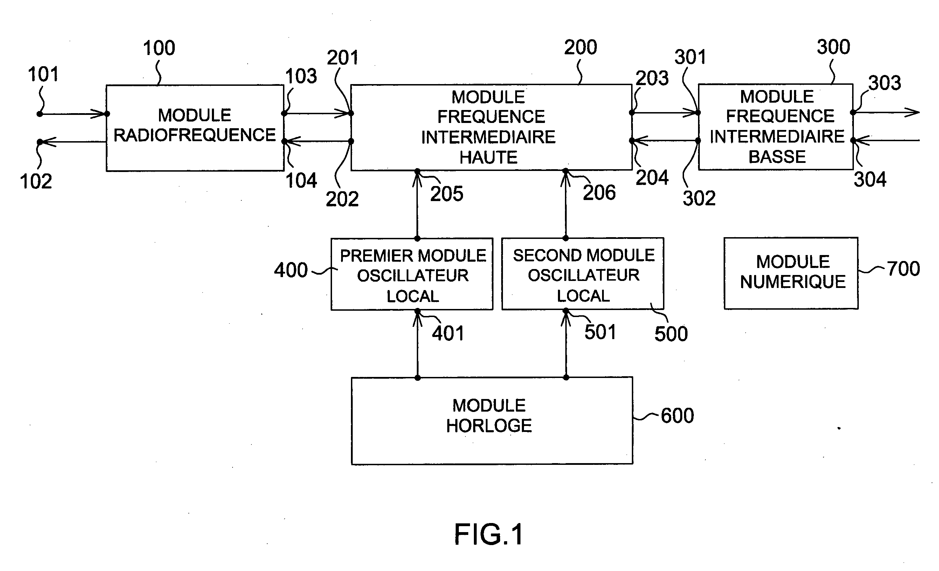

La figure 1 illustre par un synoptique les modules compris dans le module d'émission et de réception radioélectrique selon l'invention. Le module d'émission et de réception radioélectrique comporte un module radiofréquence 100. Le module radiofréquence 100 reçoit sur une première entrée 101 des signaux radioélectriques. Les signaux radioélectriques proviennent, par exemple, d'une antenne adaptée à la réception de signaux radioélectrique compris dans une bande de fréquence allant de 225 à 520 MHz (bande UHF) et d'une antenne adaptée à la réception de signaux radioélectrique compris dans une bande de fréquence allant de 30 à 88 MHz (bande VHF). Le module radiofréquence 100 présente sur une première sortie 103 les signaux radioélectriques reçus sur l'entrée 101 et éventuellement filtrés et amplifiés. Le module radiofréquence 100 reçoit sur une deuxième entrée 104 des signaux radioélectriques et les redirigent vers une ou plusieurs secondes sorties 102 après les avoir éventuellement filtrés et/ou amplifiés. Le module radiofréquence 100 peut être conçu pour traiter des signaux radioélectriques sur plusieurs bandes de fréquences différentes et de formes d'ondes multiples. Par exemple, le module radiofréquence peut traiter des formes d'ondes à évasion de fréquence s'étalant sensiblement de 30 à 600MHz.

Le module d'émission et de réception radioélectrique comporte un module fréquence intermédiaire haute 200. Le module fréquence intermédiaire reçoit sur une première entrée 201 les signaux radioélectriques envoyés sur la sortie 103 du module radiofréquence. Ces signaux radioélectriques ainsi reçus sont transposés à une fréquence intermédiaire haute. La valeur de la fréquence intermédiaire haute peut être choisie supérieure à sensiblement 2 fois la fréquence la plus élevée des signaux radioélectriques reçus par le module radiofréquence 100 sur l'entrée 101. Le choix d'une telle fréquence intermédiaire haute permet d'avoir des mélanges parasites d'ordre élevé. Les réponses parasites sont donc beaucoup moins nombreuses que pour une fréquence traditionnellement plus basse. Par exemple, avec un module radiofréquence traitant des formes d'ondes à évasion de fréquence s'étalant sensiblement de 30 à 600MHz, la fréquence intermédiaire haute peut être choisie égale à 1,22 GHz. Les signaux radioélectriques ainsi reçus, après avoir été transposés, sont envoyés sur une première sortie 203. Simultannéement, le module de fréquence intermédiaire haute, reçoit sur une deuxième entrée 204 des signaux radioélectriques dont la fréquence correspond à une fréquence intermédiaire basse (par exemple de l'ordre de 70MHz). Ces signaux sont transposés à la fréquence intermédiaire haute, puis envoyés sur une deuxième sortie 202. La sortie 202 est connectée à l'entrée 104 du module radiofréquence 100. Pour effectuer les transpositions en fréquence, le module fréquence intermédiaire haute 200 reçoit sur des troisième et quatrième entrées 205 et 206 des signaux de valeur de fréquence sensiblement connue, générés par des modules « oscillateur local » 400 et 500. Chaque module oscillateur local 400 et 500 reçoit sur une entrée,401 et 501, un même signal de référence produit par un module horloge 600. Le signal de référence a une fréquence connue. Par exemple, la fréquence peut être fixée à 160 MHz.

Le module d'émission et de réception radioélectrique comporte un module fréquence intermédiaire basse 300. Le module fréquence basse reçoit sur une première entrée 301 les signaux radioélectriques envoyés sur la sortie 203 du module fréquence intermédiaire haute. Ces signaux radioélectriques ainsi reçus sont transposés à une fréquence intermédiaire basse. Par exemple, la fréquence intermédiaire basse peut être sensiblement égale à 70 MHz. Les signaux radioélectriques ainsi reçus, après avoir été transposés, sont envoyés sur une première sortie 303. La sortie 303 peut être reliée à un modem. Parallèlement, le module de fréquence intermédiaire basse 300, reçoit sur une seconde entrée 304 des signaux radioélectriques, provenant par exemple d'un modem. Ces signaux sont transposés à la fréquence intermédiaire basse, puis envoyés sur une seconde sortie 302. La sortie 302 est connecté à l'entrée 204 du module fréquence intermédiaire haute 200.

Le module d'émission et de réception radioélectrique comporte aussi un module numérique 700. Le module numérique 700 contrôle les différents bus (non représenté) reliant les modules précités compris dans le module d'émission et de réception radioélectrique. Le module numérique peut être un composant à logique programmable, comme par exemple un composant désigné par l'acronyme anglo-saxon FPGA pour Field Programmables Gates Arrays.

Le module d'émission et de réception radioélectrique selon l'invention comporte sur une unique carte les modules précités. Chaque module comporte pour cela des moyens assurant l'étanchéité électromagnétique dudit module vis à vis des autres modules. Les moyens assurant l'étanchéité électromagnétique sont des moyens électriques (moyens de filtrage, par exemple) et mécanique (blindage). La mise en oeuvre des différents modules sur une seule carte permet à la fois de réduire significativement les coûts de conception et de production et d'améliorer la compacité volumique et la consommation électrique.

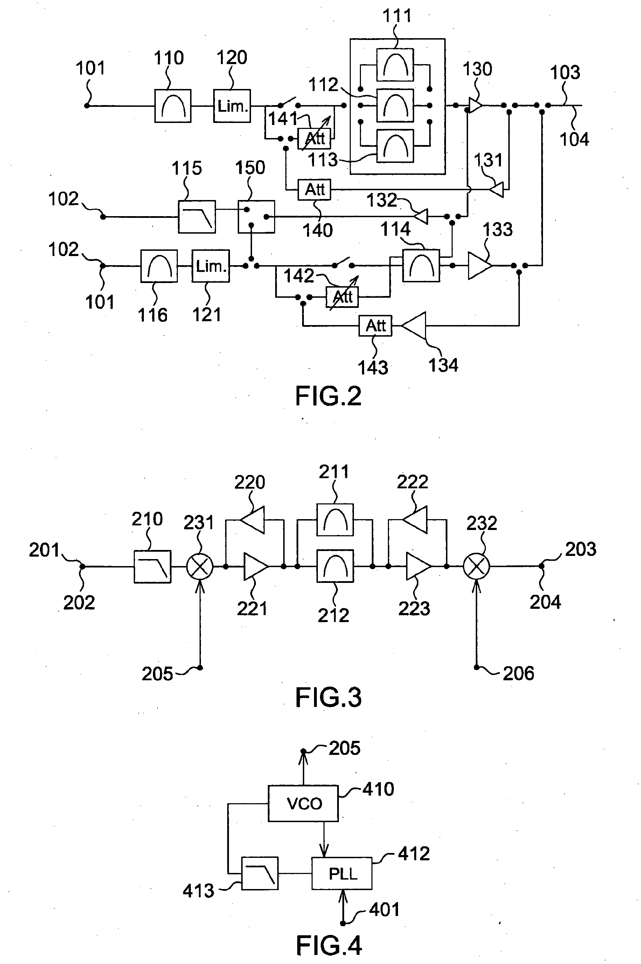

La figure 2 montre, par un synoptique, un mode de réalisation du module radiofréquence 100 selon l'invention. Les éléments identiques aux éléments déjà présentés sur les autres figures portent les mêmes références. L'entrée 101 reçoit d'une part des signaux radioélectriques sur la bande de fréquences 225 - 520 MHz (UHF) et d'autre part des signaux radioélectriques sur la bande de fréquences 30-88MHz (VHF). Le module radiofréquence 100 comporte une voie en émission (de l'entrée 104 vers la sortie 102) et une voie en réception (de l'entrée 101 vers la sortie 103) pour la bande UHF et une voie en émission (de l'entrée 104 vers la sortie 102) et une voie en réception (de l'entrée 101 vers la sortie 103) pour la bande VHF. Le mode de réalisation étant représenté à la figure 2 sous forme de synoptique, le terme voie doit être compris comme un regroupement fonctionnel et non comme une implémentation physique nécessairement séparée. Ainsi, des composants physiques peuvent bien évidemment appartenir à plusieurs voies.

La voie UHF en réception (depuis l'entrée 101 vers la sortie 103) comporte un filtre passe-bande 110, un limiteur de puissance 120, un atténuateur variable 141, un banc de filtres de suivi 111, 112, 113 et un amplificateur à faible bruit 130. Le filtre passe-bande 110 permet de couper les fréquences hautes et basses comprises éventuellement dans le signal reçu et hors de la bande UHF. Le limiteur 120 permet de limiter à un niveau de puissance donné le signal reçu. L'atténuateur variable 141 permet d'atténuer les signaux de fortes puissances pour empêcher la chaine de réception de saturer. Le banc de filtres de suivi dont la fréquence centrale varie en fonction d'une tension de commande (ou selon l'expression anglo-saxonne Tracking filter) comporte un filtre 111 passe-bande (par exemple entre 225 et 300 MHz), un filtre 112 (par exemple entre 300 et 400 MHz) et un filtre 113 passe-bande (par exemple entre 400 et 520 MHz). La bande passante de chacun de ces filtres est étroite, sensiblement égale à 8MHz. L'amplificateur à faible bruit 130 (ou selon l'expression anglo-saxonne Low Noise Amplifier) permet d'amplifier le signal filtré et limité en introduisant un bruit limité.

La voie VHF en réception (depuis l'entrée 101 vers la sortie 103) comporte un filtre passe-bande 116, un limiteur de puissance 121, un atténuateur variable 142, un filtre de suivi 114 et un amplificateur à faible bruit 133. Le filtre passe-bande 116 permet de couper les fréquences hautes et basses comprises éventuellement dans le signal reçu et hors de la bande VHF. Le limiteur 121 permet de fixer un niveau de puissance maximum pour le signal reçu. L'atténuateur variable 142 permet d'atténuer les signaux de fortes puissances pour empêcher la chaine de réception de saturer Le filtre de suivi comporte un filtre 114 passe-bande dont la fréquence centrale varie en fonction d'une la tension de commande (par exemple entre 30 et 88 MHz). La bande passante de ce filtre est étroite, sensiblement égale à 1 MHz.

La voie UHF en émission (depuis l'entrée 104 vers la sortie 102) comporte un amplificateur 131, un atténuateur 140, un atténuateur réglable et/ou variable 141, le banc de filtres de suivi comprenant les filtres passe-bande 111 112 113, un amplificateur 132, un commutateur 150 et un filtre passe-bas 115. Le filtre passe-bas 115 permet de couper les fréquences hautes éventuellement comprises dans le signal à envoyé sur la sortie 102 et hors de la bande UHF. Les atténuateurs 140 et 141 permettent de réduire selon une loi déterminée ou variable le niveau de puissance donné du signal à émettre. Le banc de filtres de suivi utilisé est partagé avec la voie UHF en réception. Le commutateur 150 a notamment pour fonction de router les signaux à émettre en bande UHF vers le filtre 115 et, in fine, à la sortie 102 adaptée.

La voie VHF en émission (depuis l'entrée 104 vers la sortie 102) comporte un amplificateur 134, un atténuateur 143, un atténuateur réglable et/ou variable 142, le filtre de suivi 114, l'amplificateur 132, le commutateur 150, un limiteur 121 et un filtre passe-bande 116. Le filtre passe-bande 116 permet de couper les fréquences basses et hautes éventuellement comprises dans le signal à envoyé sur la sortie 102 et hors de la bande VHF. Les atténuateurs 142 et 143 permettent de réduire selon une loi déterminée ou variable le niveau de puissance donné du signal à émettre. Le filtre de suivi 114 utilisé est partagé avec la voie VHF en réception. Le commutateur 150 a notamment pour fonction de router les signaux à émettre en bande VHF vers le filtre 116 et, in fine, à la sortie 102 adaptée.

La figure 3 montre par un synoptique un mode de réalisation du module fréquence intermédiaire haute 200 selon l'invention. Les éléments identiques aux éléments déjà présentés sur les autres figures portent les mêmes références. Le module fréquence intermédiaire 200 est bidirectionnel : ses fonctions sont utilisées à la fois en émission et en réception (chaîne réversible), et appliquées aux signaux dans la bande UHF et VHF. Le module 200 comporte un filtre passe-bas 210 dont la fréquence de coupure sensiblement égale à 600 MHz, un mélangeur 231, des amplificateurs 220 et 221, des filtres passe-bande 211 et 212, des amplificateurs 222 et 223, et un mélangeur 232. Le mélangeur 231 doit être sensiblement linéaire.

En réception, le signal reçu sur l'entrée 201 est envoyé au filtre passe-bas 210. Le signal filtré par le filtre passe-bas 210 est mélangé par le mélangeur 231 au signal reçu sur l'entrée 205 provenant du premier module oscillateur local 400. Le signal résultant du mélangeur 231 est ensuite amplifié 221 et filtré 212 ou 211 et amplifié 223, puis mélangé par le mélangeur 232 au signal reçu sur l'entrée 206 provenant du second module oscillateur local 500. Le signal est ensuite acheminé vers la sortie 203.

En émission, le signal reçu sur l'entrée 204 est mélangé par le mélangeur 232 au signal provenant de l'entrée 206, amplifié 222, filtré 211 ou 212 et amplifié 220. Le signal amplifié et filtré est mélangé par le mélangeur 231 au signal reçu sur l'entrée 205, puis filtré par le filtre passe-bas 210. Le signal est ensuite acheminé vers la sortie 202.

La structure du module fréquence intermédiaire haute 200 améliore les performances de réjection en fréquence intermédiaire, de réjection de fréquence image, de réjection des fréquences délivrées par les premier et second modules oscillateur local 400, 500 et de réjection des réponses parasites.

La figure 4 montre par un synoptique un mode de réalisation du premier module oscillateur local 400 selon l'invention. Les éléments identiques aux éléments déjà présentés sur les autres figures portent les mêmes références. Le premier module oscillateur local 400 comporte un oscillateur contrôlé en tension 410 (ou selon l'expression anglo-saxonne Voltage Controlled Oscillator) adapté à délivrer un signal de fréquence compris entre 1250 et 1820 MHz. Le module 400 comporte un dispositif de type boucle à verrouillage de phase 412 (ou selon l'expression anglo-saxonne Phased Lock Loop) et un filtre passe-bas 413. Le premier module oscillateur local 400 reçoit un signal sur l'entrée 401. Le signal reçu sur l'entrée 401 est un signal dont la fréquence est stable et sensiblement égal à 160 MHz, délivré par un cristal oscillant contrôlé en tension (ou selon l'expression anglo-saxonne Voltage Controlled Crystal Oscillators) compris dans le module horloge 60. Le signal reçu de l'entrée 401 pilote le dispositif de type boucle à verrouillage de phase 412 qui à son tour génère un signal transitant par le filtre 413 et pilotant la fréquence du signal généré par l'oscillateur contrôlé en tension 410. Ce signal est transmis à la sortie 205 et au dispositif de type boucle à verrouillage de phase 412 pour asservissement. Le dispositif de type boucle à verrouillage de phase 412 est un dispositif à faible consommation, et haute pureté spectrale. Le second module oscillateur local 500 comporte des éléments identiques au premier module oscillateur local 400, à la différence cependant de l'oscillateur contrôlé en tension adapté à délivrer un signal de fréquence compris entre 1150 et 1290 MHz. En outre, afin d'optimiser le nombre de canaux bouchés, la fréquence du signal émis sur la sortie 206 est choisie inférieure ou supérieure à la fréquence intermédiaire haute. La fréquence du signal émis sur la sortie 206 du second module oscillateur local 500 peut être choisie inférieure ou supérieure à la fréquence intermédiaire haute. La vitesse de changement de fréquence se fait à la vitesse de sauts en fréquence du signal émis et/ou reçu par le module d'émission et de réception radioélectrique (cas d'une forme d'onde à évasion de fréquence par exemple). Le premier module oscillateur local 400 et le second module oscillateur local 500 sont synchronisés par le signal de synchronisation du bus radio reçu par le module numérique 700. Les premier et second modules oscillateurs locaux 400 et 500 présentent la même pureté spectrale que les oscillateurs locaux des réalisations antérieures faites à des fréquences beaucoup plus basse, l'art antérieur étant en fréquence intermédiaire basse.

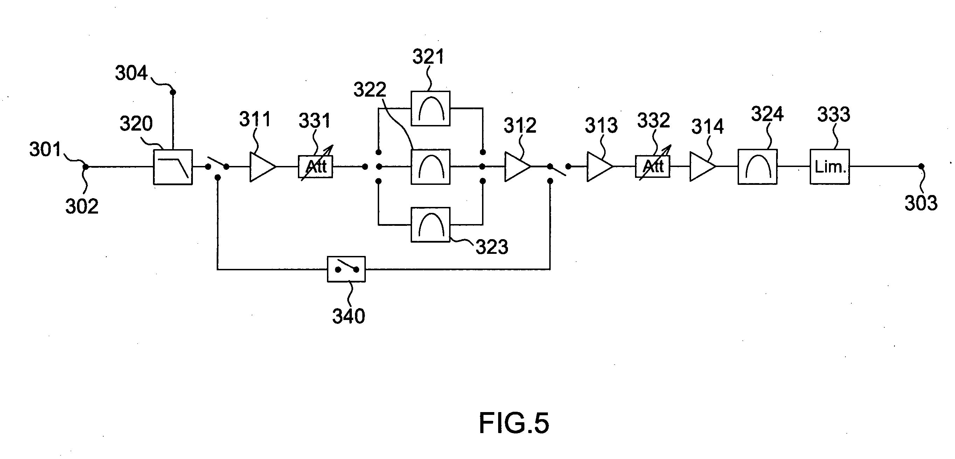

La figure 5 montre par un synoptique un mode de réalisation du module fréquence intermédiaire basse 300 selon l'invention. Les éléments identiques aux éléments déjà présentés sur les autres figures portent les mêmes références. Le module fréquence intermédiaire basse 300 est bidirectionnel : ses fonctions sont utilisées à la fois en émission et en réception (chaîne réversible), et appliquées aux signaux dans la bande UHF et VHF. Le module 300 comporte un filtre passe-bas 320 dont la fréquence de coupure sensiblement égale à 70 MHz, des amplificateurs 311, 312, 313, 314, un banc de filtres suiveur comprenant des filtres passe-bande 321 (de bande de passante centrée à 70 MHz à +/- 30KHz), 322 (de bande de passante centrée à 70 MHz à +/- 750KHz), 323 de bande de passante centrée à 70 MHz à +/- 2,5 MHz), un filtre anti-repliement 324, des atténuateurs variables 331, 332, un limiteur 333 et un commutateur 340.

En réception, le signal reçu sur l'entrée 301 est envoyé au filtre passe-bas 320. Le signal filtré par le filtre passe-bas 320 est amplifié 311, atténué 331, et filtré par le banc de filtres suiveurs, puis amplifié 312, 313, atténué 332, amplifié 314, filtré par le filtre anti-repliement 324 et limité 333. Le signal est ensuite acheminé vers la sortie 303.

En émission, le signal reçu sur l'entrée 304 est envoyé vers l'amplificateur 311. Le signal amplifié 311, est atténué 331, et filtré par le banc de filtres suiveurs, puis amplifié 312. Le signal est routé vers le commutateur 340 qui bloque ou redirige vers le filtre passe-bas 320 le signal. Le signal est ensuite acheminé vers la sortie 302.

Dans un mode de réalisation, tous les éléments non actifs du module d'émission et de réception radioélectrique selon l'invention pour un mode donné (c'est-à-dire par exemple mode émission, mode réception...) sont éteints. Ainsi, la consommation électrique est optimisée.

## Revendications

1. Module d'émission et de réception radioélectrique comportant au moins les éléments suivants :
• un module radiofréquence (100), ledit module comportant une première entrée (101) et une première sortie (103) de signaux radioélectriques formant une voie de réception, le module radiofréquence (100) filtrant et amplifiant les signaux radioélectriques reçus ;
• un module fréquence intermédiaire haute (200), ledit module comportant une première entrée (201) et une première sortie (203) de signaux radioélectriques formant une voie de réception, les signaux radioélectriques reçus étant transposés à une fréquence intermédiaire haute, ladite fréquence intermédiaire haute étant choisie au moins supérieure à sensiblement deux fois la fréquence la plus élevée des signaux radioélectriques reçus par le module radiofréquence (100) ;
• un module fréquence intermédiaire basse (300), ledit module comportant une première entrée (301) et une première sortie (303) de signaux radioélectriques formant une voie de réception, les signaux radioélectriques reçus étant transposés à une fréquence intermédiaire basse ;
**caractérisé en ce que**
• ledit module fréquence intermédiaire haute (200) comporte en outre une seconde entrée (204) et une seconde sortie (202) de signaux radioélectriques formant une voie d'émission,
• ledit module fréquence intermédiaire basse (300) comporte en outre une seconde entrée (304) et une seconde sortie (302) de signaux radioélectriques formant une voie d'émission,
• ledit module radiofréquence (100) comporte en outre une seconde entrée (104) et une seconde sortie (102) de signaux radioélectriques formant une voie d'émission,
• ledit module radiofréquence (100) reçoit sur la première entrée (101) des signaux radioélectriques sur la bande de fréquences 225 - 520 MHz, et d'autre part des signaux radioélectriques sur la bande de fréquences 30-88MHz, ledit module (100) comportant une voie en émission et une voie en réception pour la bande de fréquences 225 - 520 MHz et une voie en émission et une voie en réception pour la bande de fréquences 30-88MHz,
✔ la voie en réception (101, 103) pour la bande de fréquences 225 - 520 MHz comportant un filtre passe-bande (110), un limiteur de puissance (120), un banc de filtres de suivi comprenant des filtres (111, 112, 113) passe-bande dont la fréquence centrale varie en fonction d'une tension de commande, un atténuateur variable (141) et un amplificateur à faible bruit (130) ;
✔ la voie en réception (101,103) pour la bande de fréquences 30-88MHz comportant un filtre passe-bande (116) coupant les fréquences hautes et basses hors de ladite bande de fréquence, un limiteur de puissance (121), un filtre de suivi comprenant un filtre passe-bande (114) dont la fréquence centrale varie en fonction d'une tension de commande, un atténuateur variable (142) et un amplificateur à faible bruit (133);
✔ la voie en émission (104, 102) pour la bande de fréquences 225 - 520 MHz comportant un amplificateur (131), un atténuateur (140), un atténuateur réglable et/ou variable (141), le banc de filtres de suivi comprenant les filtres passe-bande (119, 112, 113), un amplificateur (132), un commutateur (150) et un filtre passe-bas (115) coupant les fréquences hautes hors de ladite bande de fréquence, le banc de filtres de suivi étant partagé avec la voie en réception (101, 103) pour la bande de fréquences 225 - 520 MHz, le commutateur (150) routant les signaux à émettre en bande de fréquences 225 - 520 MHz vers le filtre passe-bas (115) ;
✔ la voie en émission (104, 102) pour la bande de fréquences 30-88MHz comportant un amplificateur (134), un atténuateur (143), un atténuateur réglable et/ou variable (142), le filtre de suivi (114), l'amplificateur (132), le commutateur (150), un limiteur (121) et un filtre passe-bande (116) coupant les fréquences basses et hautes hors de ladite bande de fréquence, le filtre de suivi (114) étant partagé avec la voie en réception (101,103) pour la bande de fréquences 30-88MHz, le commutateur (150) routant les signaux à émettre en bande de fréquences 30-88MHz vers le filtre (116) ;
• le module radiofréquence, le module fréquence intermédiaire haute et le module fréquence intermédiaire basse sont isolés électriquement et mécaniquement et disposés sur une même carte

2. Module d'émission et de réception radioélectrique selon la revendication 1 **caractérisé en ce que** le module fréquence intermédiaire haute (200) reçoit sur la première entrée (201) des signaux radioélectriques sur la bande de fréquences 225 - 520 MHz, et d'autre part des signaux radioélectriques sur la bande de fréquences 30-88MHz, ledit module comportant une voie en émission et une voie en réception pour la bande de fréquences 225 - 520 MHz et une voie en émission et une voie en réception pour la bande de fréquences 30-88MHz, ledit module comportant un filtre passe-bas (210) dont la fréquence de coupure sensiblement égale à 600 MHz, un mélangeur (231), des amplificateurs (220, 221), des filtres passe-bande (211, 212), un filtre passe haut 70MHz, des amplificateurs (222, 223) et un mélangeur (232),
• pour la voie en réception, le signal reçu sur la première entrée (201) étant envoyé au filtre passe-bas (210), le signal filtré par le filtre passe-bas (210) étant mélangé par le mélangeur (231) au signal reçu sur une troisième entrée (205) reliée à un premier module oscillateur local (400), le signal résultant du mélangeur (231) étant filtré (212) et amplifié (221, 223), puis mélangé par le mélangeur (232) au signal reçu sur l'entrée 206, le signal étant acheminé vers la sortie (203) ;
• pour la voie en émission, le signal reçu sur une entrée (204) étant mélangé par le mélangeur (232) au signal provenant d'une quatrième entrée (206) reliée à un second module oscillateur local (500), filtré (211) et amplifié (222, 220), puis mélangé par le mélangeur (231) au signal reçu sur la troisième entrée (205), puis filtré par le filtre passe-bas (210), le signal étant ensuite acheminé vers la sortie (202).

3. Module d'émission et de réception radioélectrique selon la revendication 2 **caractérisé en ce que** le premier module oscillateur local (400) comporte un oscillateur contrôlé en tension (410) adapté à délivrer un signal de fréquence compris entre 1250 et 1820 MHz, ledit module comportant un dispositif de type boucle à verrouillage de phase (412) et un filtre passe-bas (413), ledit module (400) recevant sur une entrée (401) un signal dont la fréquence est sensiblement stable et sensiblement égale à 160 MHz, ledit signal étant délivré par un cristal oscillant contrôlé en tension compris dans un module horloge (60), le signal reçu de l'entrée (401) pilotant le dispositif de type boucle à verrouillage de phase (412) qui génère un signal transitant par le filtre (413) et pilotant la fréquence du signal généré par l'osciliateur contrôlé en tension (410), ce dernier signal étant transmis à la troisième entrée (205) du module fréquence intermédiaire haute (200) et au dispositif de type boucle à verrouillage de phase (412) pour asservissement.

4. Module d'émission et de réception radioélectrique selon la revendication 2 ou 3 **caractérisé en ce que** le second module oscillateur local (500) comporte un oscillateur contrôlé en tension adapté à délivrer un signal de fréquence compris entre 1150 et 1290 MHz, ledit module comportant un dispositif de type boucle à verrouillage de phase et un filtre passe-bas, ledit module (500) recevant sur une entrée un signal dont la fréquence est sensiblement stable et sensiblement égale à 160 MHz, ledit signal étant délivré par un cristal oscillant contrôlé en tension compris dans un module horloge (60), le signal reçu de l'entrée (501) pilotant le dispositif de type boucle à verrouillage de phase qui génère un signal transitant par le filtre et pilotant la fréquence du signal généré par l'oscillateur contrôlé en tension, ce dernier signal étant transmis à la quatrième entrée (206) du module fréquence intermédiaire haute (200) et au dispositif de type boucle à verrouillage de phase pour asservissement.

5. Module d'émission et de réception radioélectrique selon la revendication 4 **caractérisé en ce que** la fréquence du signal émis sur la sortie (206) est choisie inférieure ou supérieure à la fréquence intermédiaire haute, la vitesse de changement de fréquence se faisant à la vitesse de sauts en fréquence du signal émis et/ou reçu par le module d'émission et de réception radioélectrique.

6. Module d'émission et de réception radioélectrique selon l'une des quelconques revendications 1 à 5 **caractérisé en ce que** le module fréquence intermédiaire basse (300) reçoit sur la première entrée (301) des signaux radioélectriques sur la bande de fréquences intermédiaire haute, et d'autre part des signaux radioélectriques sur la bande de fréquences 30-88MHz, ledit module comportant un filtre passe-bas (320) dont la fréquence de coupure sensiblement égale à 70 MHz, des amplificateurs (311, 312, 313, 314), un banc de filtres suiveur comprenant des filtres passe-bande (321, 322, 323), un filtre anti-repliement (324), des atténuateurs variables (331, 332), un limiteur (333) et un commutateur (340),
• pour la voie en réception, le signal reçu sur la première entrée (301) étant envoyé au filtre passe-bas (320), amplifié (311), atténué (331), filtré par le banc de filtres suiveurs, puis amplifié (312, 313), atténué (332), amplifié (314), filtré par le filtre anti-repliement (324) et limité (333), le signal étant acheminé vers la seconde sortie (303) ;
• pour la voie en émission, le signal reçu sur la seconde entrée (304) étant envoyé au filtre passe-bas (320), amplifié (311), atténué (331), et filtré par le banc de filtres suiveurs, puis amplifié (312), le signal étant routé vers le commutateur (340) qui bloque ou redirige vers le filtre passe-bas (320) le signal, le signal étant acheminé vers la première sortie (302).

7. Module d'émission et de réception radioélectrique selon l'une des quelconques revendications 1 à 6 **caractérisé en ce que** tous les éléments non actifs du module d'émission et de réception radioélectrique sont éteints.

## Patentansprüche

1. Radioelektrisches Sende- und Empfangsmodul, das wenigstens die folgenden Elemente umfasst:
• ein Funkfrequenzmodul (100), wobei das Modul einen erstes Eingang (101) und einen ersten Ausgang (103) für radioelektrische Signale umfasst, die einen Empfangskanal bilden, wobei das Funkfrequenzmodul (100) die empfangenen radioelektrischen Signale filtert und verstärkt;
• ein Hohe-Zwischenfrequenz-Modul (200), wobei das Modul einen ersten Eingang (201) und einen ersten Ausgang (203) für radioelektrische Signale umfasst, die einen Empfangskanal bilden, wobei die empfangenen radioelektrischen Signale auf eine hohe Zwischenfrequenz transponiert werden, wobei die hohe Zwischenfrequenz so gewählt wird, dass sie wenigstens im Wesentlichen zweimal so hoch ist wie die höchste Frequenz der von dem Funkfrequenzmodul (100) empfangenen radioelektrischen Signale;
• ein Tiefe-Zwischenfrequenz-Modul (300), wobei das Modul einen ersten Eingang (301) und einen ersten Ausgang (303) für radioelektrische Signale umfasst, die einen Empfangskanal bilden, wobei die empfangenen radioelektrischen Signale auf eine tiefe Zwischenfrequenz transponiert werden;
**dadurch gekennzeichnet, dass**
• das Hohe-Zwischenfrequenz-Modul (200) ferner einen zweiten Eingang (204) und einen zweiten Ausgang (202) für radioelektrische Signale umfasst, die einen Sendekanal bilden,
• wobei das Tiefe-Zwischenfreque-Modul (300) ferner einen zweiten Eingang (304) und einen zweiten Ausgang (302) für radioelektrische Signale umfasst, die einen Sendekanal bilden,
• das Funkfrequenzmodul (100) ferner einen zweiten Eingang (104) und einen zweiten Ausgang (102) für radioelektrische Signale umfasst, die einen Sendekanal bilden,
• das Funkfrequenzmodul (100) am ersten Eingang (101) radioelektrische Signale auf dem Frequenzband 225 - 520 MHz und andererseits radioelektrische Signale auf dem Frenquenzband 30 - 88 MHz empfängt, wobei das Modul (100) einen Sendekanal und einen Empfangskanal für das Frequenzband 225 - 520 MHz und einen Sendekanal und einen Empfangskanal für das Frequenzband 30 - 88 MHz umfasst,
✔ wobei der Empfangskanal (101, 103) für das Frequenzband 225 - 520 MHZ ein Bandpassfilter (110), einen Leistungsbegrenzer (120), eine Folgefiltergruppe mit Bandpassfiltern (111, 112, 113), deren Mittenfrequenz in Abhängigkeit von einer Steuerspannung variiert, einen variablen Dämpfer (141) und einen Low-Noise-Verstärker (130) umfasst;
✔ wobei der Empfangskanal (101, 103) für das Frenquenzband 30 - 88 MHz ein Bandpassfilter (116), das die hohen und tiefen Frequenzen aus dem Frequenzband schneidet, einen Leistungsbegrenzer (121), ein Folgefilter mit einem Bandpassfilter (114), dessen Mittenfrequenz in Abhängigkeit von der Steuerspannung variiert, einen variablen Dämpfer (142) und einen Low-Noise-Verstärker (133) umfasst;
✔ wobei der Sendekanal (104, 102) für das Frequenzband 225 - 520 MHz einen Verstärker (131), einen Dämpfer (140), einen regelbaren und/oder variablen Dämpfer (141) umfasst, wobei die Folgefiltergruppe die Bandpassfilter (111, 112, 113), einen Verstärker (132), einen Schalter (150) und ein Tiefpassfilter (115) umfasst, das die oberen Frequenzen aus dem Frenquenzband schneidet, wobei die Folgefiltergruppe mit dem Empfangskanal (101, 103) für das Frequenzband 225 - 520 MHz gemeinsam genutzt wird, wobei der Schalter (150) die im Frequenzband 225 - 520 MHz zu sendenden Signale zum Tiefpassfilter (115) leitet;
✔ wobei der Sendekanal (104, 102) für das Frequenzband 30 - 88 MHz einen Verstärker (134), einen Dämpfer (143), einen regelbaren und/oder variablen Dämpfer (142), das Folgefilter (114), den Verstärker (132), den Schalter (150), einen Begrenzer (121) und ein Bandpassfilter (116) umfasst, das die tiefen und hohen Frequenzen aus dem Frequenzband schneidet, wobei das Folgefilter (114) mit dem Empfangskanal (101, 103) für das Frequenzband 30 - 88 MHz gemeinsam genutzt wird, wobei der Schalter (150) die im Frequenzband 30 - 88 MHz zu sendenden Signale zum Filter (116) leitet;
• wobei das Funkfrequenzmodul, das Hohe-Zwischenfrequenz-Modul und das Tiefe-Zwischenfrequenz-Modul elektrisch und mechanisch getrennt und auf einer selben Karte angeordnet sind.

2. Radioelektrisches Sende- und Empfangsmodul nach Anspruch 1, **dadurch gekennzeichnet, dass** das Hohe-Zwischenfrequenz-Modul (200) am ersten Eingang (201) radioelektrische Signale im Frequenzband 225 - 520 MHz empfängt und andererseits radioelektrische Signale auf dem Frequenzband 30 - 88 MHz empfängt, wobei das Modul einen Sendekanal und einen Empfangskanal für das Frequenzband 225 - 520 MHz und einen Sendekanal und einen Empfangskanal für das Frequenzband 30 - 88 MHz umfasst, wobei das Modul ein Tierpassfilter (210), dessen Grenzfrequenz im Wesentlichen gleich 600 MHz ist, einen Mischer (231), Verstärkter (220, 221), Bandpassfilter (211, 212), ein Hochpassfilter von 70 MHz, Verstärker (222, 223) und einen Mischer (232) umfasst,
• wobei das am ersten Eingang (201) empfangene Signal für den Empfangskanal zum Tiefpassfilter (210) gesendet wird, wobei das vom Tiefpassfilter (210) gefilterte Signal vom Mischer (231) mit dem an einem dritten Eingang (205) empfangenen Signal gemischt wird, der mit einem ersten Lokaloszillator-Modul (400) verbunden ist, wobei das Signal vom Mischer (231) gefiltert (212) und verstärkt (221, 223) und dann vom Mischer (232) mit dem am Eingang (206) empfangenen Signal gemischt wird, wobei das Signal zum Ausgang (203) geleitet wird;
• wobei das an einem Eingang (204) empfangene Signal für den Sendekanal von dem Mischer (232) mit dem Signal, das von einem mit einem zweiten Lokaloszillator-Modul (500) verbundenen vierten Eingang (206) kommt, gemischt, filtriert (211) und verstärkt (222, 220) und dann vom Mischer (231) mit dem am dritten Eingang (205) empfangenen Signal gemischt und dann vom Tiefpassfilter (210) gefiltert wird, wobei das Signal dann zum Ausgang (202) geleitet wird.

3. Radioelektrisches Sende- und Empfangsmodul nach Anspruch 2, **dadurch gekennzeichnet, dass** das erste Lokaloszillator-Modul (400) einen spannungsgesteuerten (410) Oszillator zum Liefern eines Signals mit einer Frequenz zwischen 1250 und 1820 MHz umfasst, wobei das Modul eine Phasenregelkreisvorrichtung (412) und ein Tiefpassfilter (413) umfasst, wobei das Modul (400) an einem Eingang (401) ein Signal empfängt, dessen Frequenz im Wesentlichen stabil und im Wesentlichen gleich 160 MHz ist, wobei das Signal von einem spannungsgesteuerten oszillierenden Kristall geliefert wird, das in einem Taktmodul (60) enthalten ist, wobei das vom Eingang (401) empfangene Signal die Phasenregelkreis-Vorrichtung (412) steuert, die ein Signal erzeugt, das durch das Filter (413) geht und die Frequenz des vom spannungsgesteuerten Oszillator (410) erzeugten Signals regelt, wobei dieses letztere Signal an den dritten Eingang (205) des Hohe-Zwischenfrequenz-Moduls (200) und an die Phasenregelkreisvorrichtung (412) zum Regulieren angelegt wird.

4. Radioelektrisches Sende- und Empfangsmodul nach Anspruch 2 oder 3, **dadurch gekennzeichnet, dass** das zweite Lokaloszillator-Modul (500) einen spannungsgesteuerten Oszillator zum Liefern eines Signals mit einer Frequenz zwischen 1150 und 1290 MHz umfasst, wobei das Modul eine Phasenregelkreisvorrichtung und ein Tiefpassfilter umfasst, wobei das Modul (500) an einem Eingang ein Signal empfängt, dessen Frequenz im Wesentlichen stabil und im Wesentlichen gleich 160 MHz ist, wobei das Signal von einem spannungsgesteuerten oszillierenden Kristall geliefert wird, das sich in einem Taktmodul (60) befindet, wobei das empfangene Signal von Eingang (501) die Phasenregelkreis-Vorrichtung steuert, die ein Signal erzeugt, das durch das Filter geht und die Frequenz des vom spannungsgesteuerten Oszillator erzeugten Signals regelt, wobei dieses letztere Signal an den vierten Eingang (206) des Hohe-Zwischenfrequenz-Moduls (200) und an die Phasenregelkreisvorrichtung zum Regulieren angelegt wird.

5. Radioelektrisches Sende- und Empfangsmodul nach Anspruch 4, **dadurch gekennzeichnet, dass** die Frequenz des am Ausgang (206) ausgestrahlten Signals so gewählt wird, dass sie tiefer oder höher ist als die hohe Zwischenfrequenz, wobei die Frequenzänderungsgeschwindigkeit der Frequenzsprunggeschwindigkeit des von dem radioelektrischen Sender- und Empfangsmodul gesendeten und/oder empfangenen Signals entspricht.

6. Radioelektrisches Sende- und Empfangsmodul nach einem der Ansprüche 1 bis 5, **dadurch gekennzeichnet, dass** das Tiefe-Zwischenfrequenz-Modul (300) am ersten Eingang (301) radioelektrische Signale im Hohe-Zwischenfrequenz-Band und andererseits radioelektrische Signale im Frequenzband 30-88 MHz empfängt, wobei das Modul ein Tiefpassfilter (320), dessen Grenzfrequenz im Wesentlichen gleich 70 MHz ist, Verstärker (311, 312, 313, 314), eine Folgefiltergruppe mit Bandpassfiltern (321, 322, 323), ein Antifaltungsfilter (324), variable Dämpfer (331, 332), einen Begrenzer (333) und einen Schalter (340) umfasst,
• wobei für den Empfangskanal das am ersten Eingang (301) empfangene Signal zum Tiefpassfilter (320) gesendet, verstärkt (311), gedämpft (331), von der Folgefiltergruppe filtriert, dann verstärkt (312, 313), gedämpft (332), verstärkt (314), vom Antifaltungsfilter (324) filtriert und begrenzt (333) wird, wobei das Signal zum zweiten Ausgang (303) geleitet wird;
• wobei das am zweiten Eingang (304) empfangene Signal für den Sendekanal zum Tiefpassfilter (320) gesendet, verstärkt (311), gedämpft (331) und von der Folgefiltergruppe gefiltert, dann verstärkt (312) wird, wobei das Signal zum Schalter (340) geleitet wird, der das Signal sperrt oder zum Tiefpassfilter (320) umleitet, wobei das Signal zum ersten Ausgang (302) geleitet wird.

7. Radioelektrisches Sende- und Empfangsmodul nach einem der Ansprüche 1 bis 6, **dadurch gekennzeichnet, dass** alle nichtaktiven Elemente des radioelektrischen Sende- und Empfangsmoduls ausgeschaltet werden.

## Claims

1. Radioelectric transmission and reception module comprising at least the following elements:
• a radiofrequency module (100), the module comprising a first input (101) and a first output (103) for radioelectric signals forming a reception channel, the radiofrequency module (100) filtering and amplifying the radioelectric signals received;
• a high intermediate frequency module (200), the module comprising a first input (201) and a first output (203) for radioelectric signals which form a reception channel, the radioelectric signals received being transposed at a high intermediate frequency, the high intermediate frequency being selected to be at least greater than substantially twice the highest frequency of the radioelectric signals received by the radiofrequency module (100);
• a low intermediate frequency module (300), the module comprising a first input (301) and a first output (303) for radioelectric signals which form a reception channel, the radioelectric signals received being transposed at a low intermediate frequency,
**characterised in that**
• the high intermediate frequency module (200) further comprises a second input (204) and a second output (202) for radioelectric signals which form a transmission channel,
• the low intermediate frequency module (300) further comprises a second input (304) and a second output (302) for radioelectric signals which form a transmission channel,
• the radiofrequency module (100) further comprises a second input (104) and a second output (102) for radioelectric signals which form a transmission channel,
• the radiofrequency module (100) receives at the first input (101) radioelectric signals on the frequency bands 225-520 MHz and, on the other hand, radioelectric signals on the frequency band 30-88 MHz, the module (100) comprising a transmission channel and a reception channel for the frequency band 225-520 MHz and a transmission channel and a reception channel for the frequency band 30-88 MHz,
✔ the reception channel (101, 103) for the frequency band 225-520 MHz comprising a band pass filter (110), a power limiter (120), a bank of tracking filters comprising band pass filters (111, 112, 113) whose central frequency varies in accordance with a control voltage, a variable attenuator (141) and a low-noise amplifier (130);
✔ the reception channel (101, 103) for the frequency band 30-88 MHz comprising a band pass filter (116) which cuts the high and low frequencies from the frequency band, a power limiter (121), a tracking filter comprising a band pass filter (114) whose central frequency varies in accordance with a control voltage, a variable attenuator (142) and a low-noise amplifier (133);
✔ the transmission channel (104, 102) for the frequency band 225-520 MHz comprising an amplifier (131), an attenuator (140), a controllable and/or variable attenuator (141), the bank of tracking filters comprising the band pass filters (111, 112, 113), an amplifier (132), a commutator (150) and a low pass filter (115) which cuts the high frequencies from the frequency band, the bank of tracking filters being shared with the reception channel (101, 103) for the frequency band 225-520 MHz, the commutator (150) routing the signals to be transmitted in the frequency band 225-520 MHz towards the low pass filter (115);
✔ the transmission channel (104, 102) for the frequency band 30-88 MHz comprising an amplifier (134), an attenuator (143), a controllable and/or variable attenuator (142), the tracking filter (114), the amplifier (132), the commutator (150), a limiter (121) and a band pass filter (116) which cuts the low and high frequencies from the frequency band, the tracking filter (114) being shared with the reception channel (101, 103) for the frequency band 30-88 MHz, the commutator (150) routing the signals to be transmitted in the frequency band 30-88 MHz to the filter (116);
• the radiofrequency module, the high intermediate frequency module and the low intermediate frequency module are electrically and mechanically isolated and arranged on the same board.

2. Radioelectric transmission and reception module according to claim 1, **characterised in that** the high intermediate frequency module (200) receives at the first input (201) radioelectric signals on the frequency band 225-520 MHz and, on the other hand, radioelectric signals on the frequency band 30-88 MHz, the module comprising a transmission channel and a reception channel for the frequency band 225-520 MHz and a transmission channel and a reception channel for the frequency band 30-88 MHz, the module comprising a low pass filter (210) whose cutoff frequency is substantially equal to 600 MHz, a mixer (231), amplifiers (220, 221), band pass filters (211, 212), a high pass filter 70 MHz, amplifiers (222, 223) and a mixer (232),
• for the reception channel, the signal received at the first input (201) being sent to the low pass filter (210), the signal filtered by the low pass filter (210) being mixed by the mixer (231) with the signal received at a third input (205) connected to a first local oscillator module (400), the signal resulting from the mixer (231) being filtered (212) and amplified (221, 223), then mixed by the mixer (232) with the signal received at the input (206), the signal being conveyed to the output (203);
• for the transmission channel, the signal received at an input (204) being mixed by the mixer (232) with the signal originating from a fourth input (206) connected to a second local oscillator module (500), filtered (211) and amplified (222, 220), then mixed by the mixer (231) with the signal received at the third input (205), then filtered by the low pass filter (210), the signal then being conveyed to the output (202).

3. Radioelectric transmission and reception module according to claim 2, **characterised in that** the first local oscillator module (400) comprises an oscillator which is controlled in terms of voltage (410) and which is capable of supplying a frequency signal between 1250 and 1820 MHz, the module comprising a phase locked loop type device (412) and a low pass filter (413), the module (400) receiving at an input (401) a signal whose frequency is substantially and substantially equal to 160 MHz, the signal being supplied by an oscillating crystal which is controlled in terms of voltage and which is incorporated in a clock module (60), the signal received from the input (401) controlling the device of the phase locked loop type (412) which generates a signal which passes through the filter (413) and which controls the frequency of the signal generated by the oscillator which is controlled in terms of voltage (410), this last signal being transmitted to the third input (205) of the high intermediate frequency module (200) and to the device of the phase locked loop type (412) for compelled signalling.

4. Radioelectric transmission and reception module according to claim 2 or 3, **characterised in that** the second local oscillator module (500) comprises an oscillator which is controlled in terms of voltage and which is capable of supplying a signal having a frequency between 1150 and 1290 MHz, the module comprising a phase locked loop type device and a low pass filter, the module (500) receiving at an input a signal whose frequency is substantially stable and substantially equal to 160 MHz, the signal being supplied by an oscillating crystal which is controlled in terms of voltage and which is incorporated in a clock module (60), the signal received from the input (501) controlling the device of the phase locked loop type which generates a signal which passes through the filter and which controls the frequency of the signal generated by the oscillator which is controlled in terms of voltage, this last signal being transmitted to the fourth input (206) of the high intermediate frequency module (200) and to the phase locked loop type device for compelled signalling.

5. Radioelectric transmission and reception module according to claim 4, **characterised in that** the frequency of the signal transmitted at the output (206) is selected to be less than or greater than the high intermediate frequency, the frequency change speed being carried out at the speed of frequency jumps of the signal transmitted and/or received by the radioelectric transmission and reception module.

6. Radioelectric transmission and reception module according to any one of claims 1 to 5, **characterised in that** the low intermediate frequency module (300) receives at the first input (301) radioelectric signals on the upper intermediate frequency band and, on the other hand, radioelectric signals on the frequency band 30-88 MHz, the module comprising a low pass filter (320) whose cutoff frequency is substantially equal to 70 MHz, amplifiers (311, 312, 313, 314), a tracking filter bank comprising band pass filters (321, 322, 323), an anti-folding filter (324), variable attenuators (331, 332), a limiter (333) and a commutator (340),
• for the reception channel, the signal received at the first input (301) being sent to the low filter (320), amplifies (311), attenuated (331), filtered by the bank of tracking filters, then amplified (312, 313), attenuated (332), amplified (314), filtered by the anti-folding filter (324) and limited (333), the signal being conveyed to the second output (303);
• for the transmission channel, the signal received at the second input (304) being sent to the low pass filter (320), amplified (311), attenuated (331), and filtered by the bank of tracking filters, then amplified (312), the signal being routed towards the commutator (340) which blocks or redirects the signal to the low pass filter (320), the signal being conveyed to the first output (302).

7. Radioelectric transmission and reception module according to any one of claims 1 to 6, **characterised in that** all the non-active elements of the radioelectric transmission and reception module are switched off.
